# EUROPEAN PATENT SPECIFICATION

(11) **EP 0 428 916 B1**
(45) Date of publication and mention of the grant of the patent: **14.01.1998**
(21) Application number: 90120908.0
(22) Date of filing: 31.10.1990
(51) Int. Cl.: H01L 23/48, H01L 23/051, H01L 29/32

(54) **Compression contacted semiconductor device and method for making of the same**
Druckkontakt-Halbleiteranordnung und Verfahren zum Herstellen derselben
Dispositif semi-conducteur à contact par pression et son procédé de fabrication

(30) Priority: 31.10.1989 JP 283736/89
(43) Date of publication of application: 29.05.1991
(73) Proprietor: KABUSHIKI KAISHA TOSHIBA, Kawasaki-shi (JP)
(72) Inventor: Kitagawa, Mitsuhiko, c/o Intellectual Prop. Div., Minato-ku, Tokyo 105 (JP); Yokota, Yoshio, c/o Intellectual Property Div., Minato-ku, Tokyo 105 (JP); Watanuki, Kazuo, c/o Intellectual Property Div., Minato-ku, Tokyo 105 (JP)
(74) Representative: Ritter und Edler von Fischern, Bernhard,Dipl.-Ing.

(56) References cited:
- WO-A-87/01866
- GB-A- 1 124 176
- US-A- 4 620 211
- PATENT ABSTRACTS OF JAPAN, vol. 7, no. 162 (E-187)[1307], 15th July 1983; & JP-A-58 071 658
- PATENT ABSTRACTS OF JAPAN, vol. 8, no. 4 (E-220)[1441], 10th January 1984; & JP-A-58 169 972
- SOLID-STATE ELECTRONICS, vol. 30, no. 2, February 1987, pages 185-188, Pergamon Journals Ltd, Exeter, Devon, GB; A. MOGRO-CAMPERO et al.: "Temperature behavior and annealing of insulated gate transistors subjected to localized lifetime control by proton implantation"
- NEW ELECTRONICS, vol. 16, no. 20, October 1983, pages 71-74, London, GB; L. MARECHAL: "Designing with the COMFET"

## Description

The present invention relates to a power semiconductor device and, more particularly, to a compression bonded semiconductor device in which a breakdown voltage of the semiconductor device is increased.

In a conventional power semiconductor device, in order to satisfy conditions such as heat dissipation, current capacity, breakdown resistance, a diameter of a semiconductor pellet, a compression bonded package such as a stud or flat package is used. However, since a special junction edge region such as a beveled structure is used as a junction structure of the semiconductor pellet to obtain a higher breakdown voltage, it is difficult to compress the pellet to all surfaces of portions which generate heat during an operation time. According to the above compression bonded package, in the surface of the semiconductor pellet which generates heat, heat dissipation of a portion with which a compression bonded electrode is in tight contact is excellent, but heat dissipation of a portion with which the compression bonded electrode is not in contact is very poor.

In a conventional compression bonded semiconductor device using such a compression bonded package, as countermeasures to heat dissipation, the area of a portion where an external electrode is in contact with a semiconductor pellet is maximized, or a heat buffer plate made of molybdenum (Mo), tungsten (W), or the like, which has a thermal expansion coefficient close to that of the semiconductor pellet (silicon pellet) is fixed on one surface of the semiconductor pellet through an Aℓ-Si alloy film.

Even when the above structures are used, heat dissipation of a portion with which an external electrode is not in contact is poor, and a semiconductor element may be destroyed.

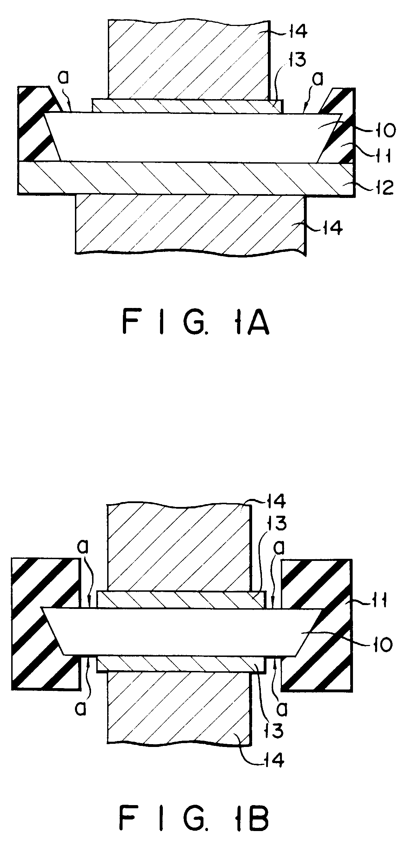

Figs. 1A and 1B schematically show a conventional alloy compression bonded diode and a conventional alloy free compression bonded diode, respectively. In Figs. 1A and 1B, reference numeral 10 denotes a semiconductor pellet (silicon pellet) on which a p-n junction diode is formed, and main electrodes are formed on one (first) major surface and the other (second) major surface, respectively. An encapsulating member (e.g., silicone rubber) 11 is provided to cover the edge surface portion of the semiconductor pellet 10.

In the alloy structure shown in Fig. 1A, one surface of the semiconductor pellet 10 is fixed on a heat buffer plate (e.g., Mo) 12 by alloy bonding, and an electrode member 13 is arranged on the other surface of the semiconductor pellet 10. The semiconductor pellet 10 is compressed from both the sides by electrode posts (e.g., Cu) 14.

In the alloy-free structure shown in Fig. 1B, electrode posts 14 compress the electrode members 13, which in turn compress the the two electrodes formed on the first and second major surfaces of the semiconductor pellet 10, respectively. The pellet 10 is compressed between the electrode members 13, but not fastened thereto. Either member 13 is compressed between the pellet 10 and the electrode post 14, but not fixed to the pellet 10 or the post 14.

Although portions of edge regions which are not covered with the electrodes 13 of the semiconductor pellets 10 shown in Figs. 1A and 1B and which are indicated by arrows a (portions of the surfaces of the semiconductor pellets 10 with which external electrodes are not in contact) generate heat during an operation time, the portions have poor heat dissipation. For this reason, when the semiconductor pellet 10 is a diode, the edge region which is not covered with the electrode 13 and which is indicated by the arrow a is maximumly easily destroyed by a back power at a reverse recovery time.

As has been described above, according to a conventional compression bonded semiconductor device, a portion with which an external electrode is not in contact within the surface of a semiconductor pellet has poor heat dissipation, and the breakdown voltage of a semiconductor element is decreased.

Patent Abstracts of Japan, vol. 7, no. 162, (E-187) (1307) July 15, 1983 & JP-A-58 071 658, which is considered to represent the most relevant state of the art, discloses a pressure contact type semiconductor device whose reliability is improved by reducing the minority carrier lifetime of a semiconductor element substrate under the periphery of a metal stamp contacted under pressure.

Solid State Electronics, vol. 30, no. 2, pp. 185-188 (1987) discloses a way of reducing the carrier lifetime by proton implantation.

It is the object of the present invention to reduce the amount of heat generation from a portion within a surface of a semiconductor pellet which does not sufficiently conduct heat to an external electrode and to increase a breakdown voltage of a semiconductor element.

This object is solved by a compression contacted semiconductor device according to claim 1, which semiconductor is further developed by the features as given in claims 2 to 13. Further, the object is solved by a method of forming a compression contacted semiconductor device according to claim 14, which method is further developed by the features according to claims 15 to 19.

This invention can be more fully understood from the following detailed description when taken in conjunction with the accompanying drawings, in which:
Figs. 1A and 1B are partial sectional views schematically showing an alloy structure and an alloy free (alloyless) structure of conventional compression bonded diodes, respectively;
Fig. 2 is a sectional view showing a main part of an alloy free compression bonded diode according to an embodiment of the present invention;
Fig. 3 is a graph showing values obtained by measuring backward breakdown voltages V_{IJ} of the compression bonded diode in Fig. 2 and a conventional alloy free compression bonded diode;
Fig. 4 is a sectional view showing a main part of a modification of the compression bonded diode in Fig. 2,
Fig. 5 is a sectional view showing a part of an alloy free reverse blocking GTO thyristor in which a carrier life time is partially controlled by electron beam radiation;
Fig. 6 is a sectional view showing a part of an alloy free reverse blocking GTO thyristor in which a carrier life time is partially controlled by proton radiation;
Figs. 7A and 7B are sectional views showing a part of an alloy free reverse conducting GTO thyristor in which a carrier life time is partially controlled by electron beam radiation;
Fig. 8 is a sectional view showing a part of an alloy free reverse conducting GTO thyristor in which a carrier life time is partially controlled by proton radiation;
Fig. 9 is a sectional view showing a part of a compression bonded diode having a non-beveled junction edge;
Fig. 10 is a sectional view showing a part of an alloy free MAGTO thyristor having a RESURF structure;
Fig. 11 is a sectional view showing a part of a MOS controlled thyristor having a RESURF structure; and
Fig. 12 is a sectional view showing a part of a double gate MOS controlled thyristor having a RESURF structure.

An embodiment of the present invention will be described below with reference to the accompanying drawings.

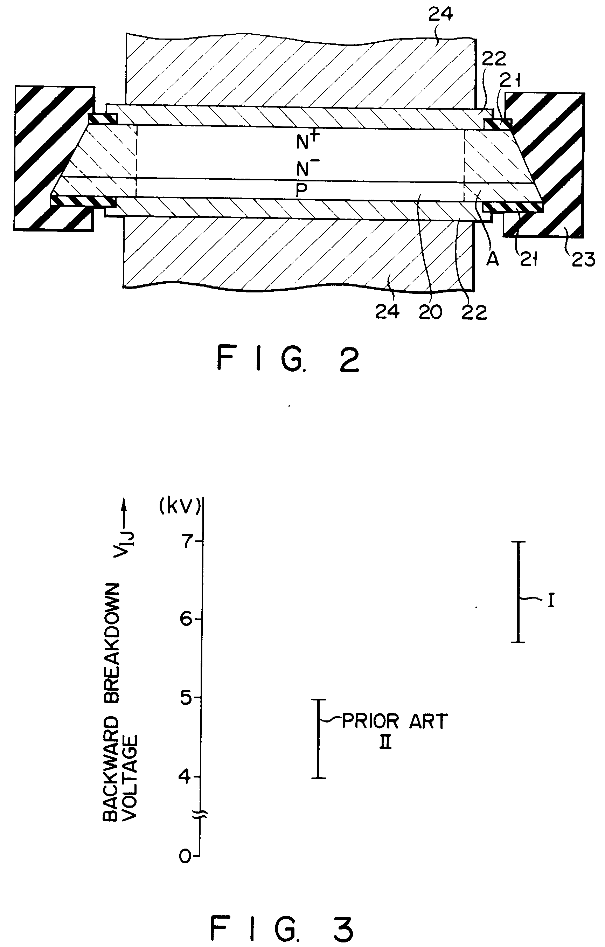

Fig. 2 is a sectional view showing a main part of an alloy free compression bonded diode. In Fig. 2, reference numeral 20 denotes a semiconductor pellet (silicon pellet) on which a diode formed by bonding p-type, n⁻-type, and n⁺-type layers is formed. In the semiconductor pellet 20, oxide films (SiO₂ films) 21 are formed on edge portions of a (first) major surface of one surface side and of a (second) major surface of the other surface side, and anode or cathode electrodes 22, 22 are formed on the entire surface. Encapsulating members (e.g., silicone rubber) 23 cover the edge surfaces of the semiconductor pellet 20. Electrode members 24 made of, for example, Mo are arranged in contact with the electrodes 22. Electron posts (not shown) made of, for example, Cu compress the electrode members 24, which sandwich and compress the semiconductor pellet 20. The semiconductor pellet 20 is pressed by the electrode members 24, but not fixed thereto. The members 24 are pressed by the electron posts, but not secured thereto. Hence, any two adjacent components contacting each other can independently contract or expand as they are cooled or heated.

In the first embodiment, a crystal defect density is distributed within the surface of the semiconductor pellet so that a carrier life time of heat generating portions (edge regions of the pellet) of the semiconductor pellet which are located outside portions where the electrode members 24 contact the electrodes 22 and cannot sufficiently conduct heat to the electrode members is shorter than that of heat generating portions which sufficiently conduct heat to the electrode members 24 and that the portions which do not sufficiently conduct heat to the electrode members 24 has a value larger than that of the portions which sufficiently conduct heat to the electrode members 24.

A method of forming the semiconductor pellet 20 of the compression bonded diode will be described below. A first electron beam is uniformly radiated onto the entire surface of the semiconductor pellet 20 at an acceleration voltage of 10 MeV and a dose of 5 × 10¹¹ cm⁻² to sufficiently decrease the carrier life time of the whole pellet, and electric characteristics of a semiconductor element close to a target can be obtained. Note that the carrier life time may be decreased by applying a radiation. Thereafter, a second electron beam having a dose (5 × 10¹² cm⁻²) which is ten times of that when the electron beam is radiated onto the entire surface is radiated onto at least edge portions of the pellet except for a portion which contacts the electrode members 24 in the pellet for generating heat by supplying a current to obtain a sufficient heat dissipation effect. The second electron beam can be applied at a dose equal to or greater than the dose of the first beam. In this case, as a mask used for selective radiation of the electron beam, an Mo plate having a thickness of about 3 to 6 mm, or the like is used. Since electron beam-irradiated portions A (regions indicated by dotted oblique lines) to which electron beam injection (EBI) is performed are not in contact with the electrode member 24, the portions A have poor heat dissipation. However, the portions A have a crystal defect density serving as a recombination center of carriers is 1.5 or more times of heat generating portions which sufficiently conduct heat to the electrode members 24 in the pellet. Depending on elements, actual crystal defect densities are 1 × 10¹⁰ cm⁻³ and about 1 × 10¹² to 1 × 10¹⁴ cm⁻³ in heat generating portions which sufficiently conduct heat to the electrode members and heat generating portions which do not sufficiently conduct heat to the electrode member, respectively.

In the compression bonded diode of the above embodiment, heat is effectively dissipated from the heat generating portion of the pellet compressed between the electrode members 24. On the contrary, although the heat dissipation of heat generating portions (i.e., electron beam irradiated portions A) of pellet edge portions which do not contact the electrode members 24 is poor, a carrier life time of the heat generating portions is decreased compared with that of the heat generating portions contacting the electrode members 24. Therefore, it is confirmed that a current is difficult to flow through the portion not contacting the electrode members 24, that a current share to these portions decreases, thereby suppressing an amount of heat generated, and that a backward breakdown voltage at a reverse recovery time can be increased. Since a temperature is increased at a position corresponding to the outer edge of the electrode member 24 due to heat transmitted from the outside, an electron beam is preferably radiated onto a small portion located inside from the outer edge of the electrode member 24.

Fig. 3 shows a resultant value obtained by measuring backward breakdown voltages V_{IJ} of the compression bonded diode of the above embodiment (I) and a conventional alloy free compression bonded diode (II). As is apparent from Fig. 3, the backward breakdown voltage V_{IJ} of the above embodiment is about 1.5 times that of a prior art.

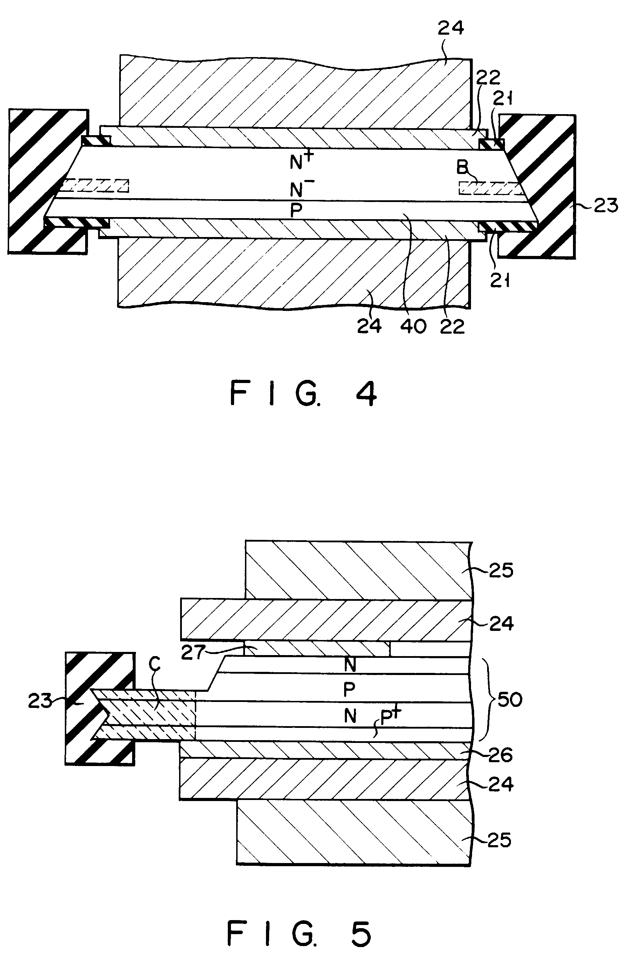

As a method of partially controlling the carrier life time described above, not only an electron beam but a radiation such as α-rays can be used, or a heavy metal may be diffused. A case wherein a proton beam is used is shown in Fig. 4. In a compression bonded diode shown in Fig. 4, in place of the electron beam, a proton beam is radiated onto a pellet edge portion to form proton irradiated portions B (regions indicated by dotted oblique lines) in the direction of depth in which a carrier life time is locally short. According to this control for a carrier life time by radiating the proton beam, a crystal defect density can be controlled within not only the surface of the semiconductor pellet 40 but in the direction of depth. Therefore, the above-described effect can be easily obtained. The position in the direction of depth is changed depending on application elements, and not only a single element position but a plurality of element positions may be provided. As a mask for selectively radiating the proton beam, an Aℓ plate having a thickness of about 0.2 to 1 mm can be satisfactorily used. This thickness is 1/2 to 1/10 that of the mask through which the electron beam is applied. When the position in the direction of depth is formed at a shallow portion having a depth of 200 µm or less from a major surface, a polyimide mask, a resist mask, a metal mask, or the like used in a conventional step can be used as a mask. In this case, the mask can be formed in the same manner as other conventional masking processes for semiconductor elements. Therefore, it is very useful in a manufacturing technique that a region having a high crystal defect density is formed at the shallow position having a depth of 200 µm or less.

In a compression bonded diode shown in Fig. 4, the same reference numerals in Fig. 4 denote the same parts as in the compression bonded diode shown in Fig. 1.

Although a compression bonded diode is shown as an example in each of the above embodiments, the present invention can be applied to all compression bonded semiconductor devices such as composite elements, e.g., conventional thyristors, a GTO (gate turn off) thyristor, an SI (static induction) thyristor, an IGBT (insulated gate bipolar transistor), an MAGT (MOS assisted gate trigger) thyristor, an MAGTO (MOS assisted gate turn off) thyristor, a reverse blocking GTO thyristor, a reverse conducting GTO thyristor, MCT (MOS controlled thyristor).

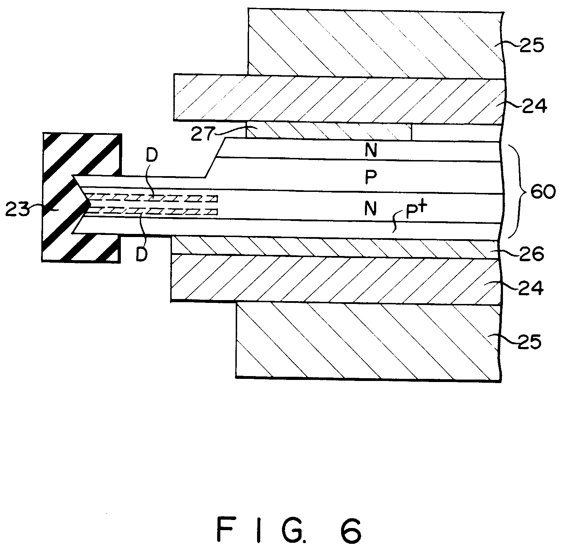

Fig. 5 is a sectional view showing a part of an alloy free reverse blocking GTO thyristor in which a carrier life time is partially controlled by electron beam radiation, and Fig. 6 is a sectional view showing a part of an alloy free reverse blocking GTO thyristor in which a carrier life time is partially controlled by proton beam radiation. Both semiconductor pellets 50 and 60 have a Σ-shaped double beveled structure.

In the case of the pellet 50, an electron beam is applied to at least the heat-generating portion which cannot transmit sufficient heat to the electron members 24, thereby forming a beam-irradiated portion C.

In the case of the pellet 60, a proton beam is applied to at least the heat-generating portion which cannot transmit sufficient heat to the electron member, thereby forming a beam-irradiated portion D. It is possible to form a beam-irradiated portion D' of a different depth, if necessary, by varying an acceleration voltage of the proton beam. Note that reference numeral 23 denotes an encapsulating member; 24, electrode members; 25, electrode posts (e.g., Cu) arranged to compress both the surfaces of the semiconductor pellets 50 and 60 through the electrode members 24; 26, an anode electrode; and 27, a gate electrode.

According to the reverse blocking GTO thyristor, since a carrier life time is sufficiently short at, at least, pellet edge portions, a current share to the edge portions in pellet surfaces decreases, thereby suppressing heat generation. The following additional effect can be obtained. That is, when an amount of carrier injection is decreased, a turn-off time is shortened.

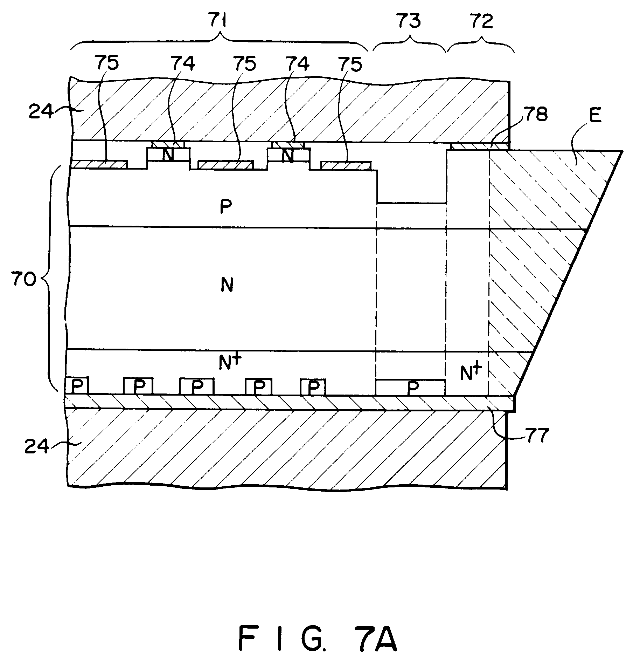

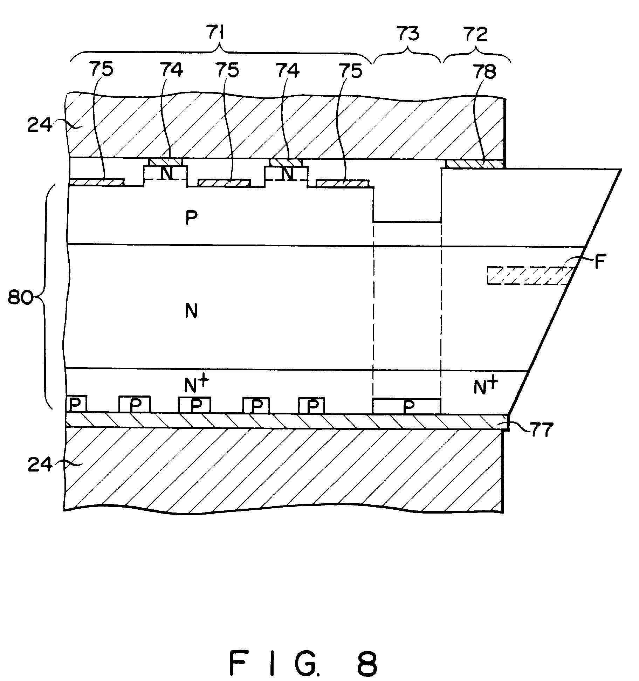

Fig. 7A is a sectional view showing a part of an alloy free reverse conducting GTO thyristor in which a carrier life time is partially controlled by electron beam radiation, and Fig. 8 is a sectional view showing a part of an alloy free reverse conducting GTO thyristor in which a carrier life time is partially controlled by proton beam radiation. A GTO thyristor 71 is formed at the lu center of a pellet (70, 80) as shown in Figs. 7A and 8, and a fly-wheel diode portion 72 is formed at the edge of the pellet. An isolating region 73 is formed between the GTO thyristor 71 and the fly-wheel diode portion 72.

In the case of the pellet shown in Fig. 7A, an electron beam is applied to at least the heat-generating portion which cannot transmit sufficient heat to the electron members 24, thereby forming a beam-irradiated portion E indicated dotted oblique lines.

In the case of the pellet shown in Fig. 8, a portion beam is applied to at least the heat-generating portion which cannot transmit sufficient heat to the electron member, thereby forming a beam-irradiated portion F indicated dotted oblique lines. Note that, in the GTO portion 71, reference numerals 74 denote cathode electrodes formed on a plurality of micropatterned emitter regions; 75, gate electrodes arranged to surround the cathode electrodes 74; 78, a cathode electrode of the diode portion 72; and 77, a common anode electrode formed one surface of the pellet.

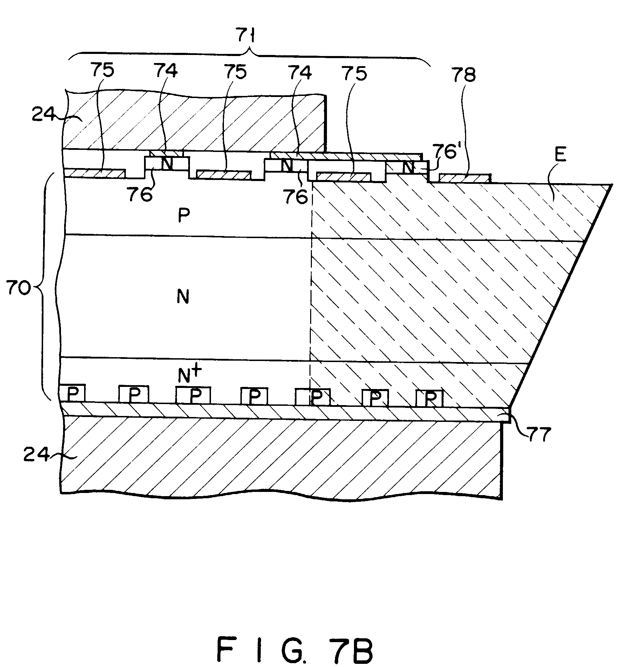

In the thyristor shown in Fig. 7A, as shown in Fig. 7B, when a part 76' of an emitter patterns 76 of the semiconductor pellet is offset from a portion immediately below the electrode members 24 and connected by only the cathode electrodes 74, heat is generated even from the part 76', and the element may be destroyed. Therefore, according to the present invention, a radioactive beam is radiated onto the portion in which an emitter pattern is arranged and which is offset from the position immediately below of the electrode members of the semiconductor pellet which do not sufficiently conduct heat to the electrode member 24, and destruction of the element can be prevented. In this case, the present invention is very useful.

Although a compression semiconductor device having a beveled structure is shown in the above embodiment, even when the present invention is applied to a compression bonded semiconductor device such as guard ring, RESURF, or resistive field plate (RFP) semiconductors using junction edges other than the beveled junction edge of the main junction, the same effect as described above can be obtained.

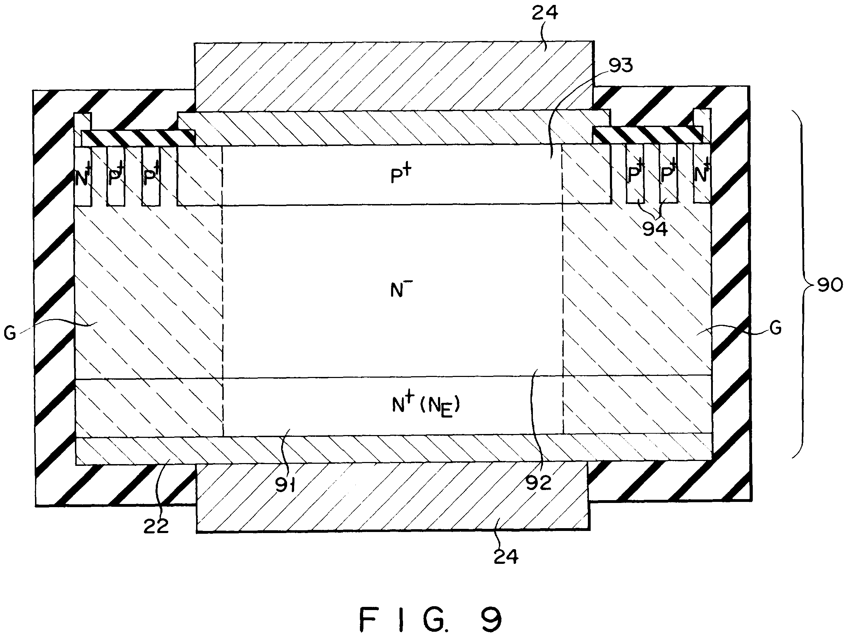

Fig. 9 shows a compression bonded diode having a non-beveled junction edge. This diode comprises an n⁺-type region 91, an n⁻-type region 92, and a p⁺-type region 93, and the p⁺-type region 93 is formed on the surface of the n⁻-type region 92 in a well form. A p-n junction is exposed on the upper surface of the semiconductor pellet. In this diode, a plurality of guard rings 94 formed by p⁺-type regions are formed on the upper surface of the semiconductor pellet to surround the p-n junction.

In this diode, in order to increase the breakdown voltage of the guard ring portions, an electron beam is radiated onto a region including the upper edge of the p-n junction of the pellet edge portion to control a carrier life time, thereby forming an electron beam radiated portion G.

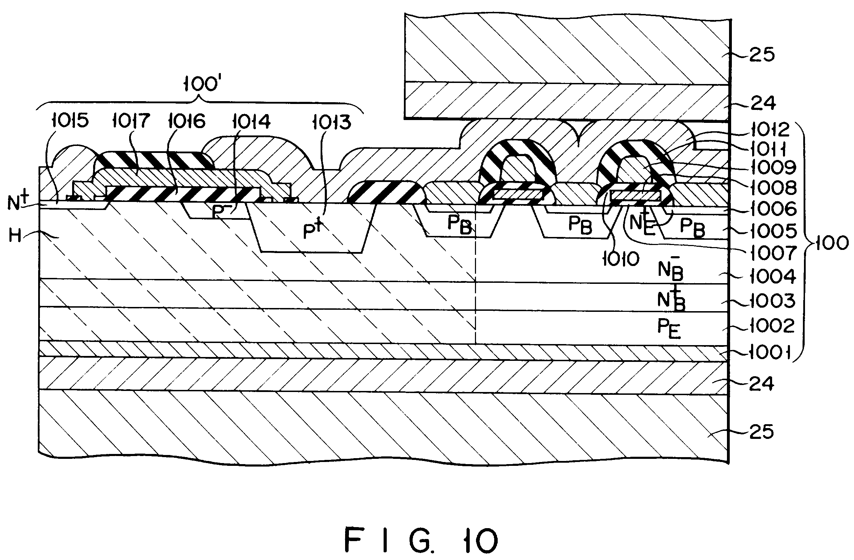

Fig. 10 shows a part of an alloy free MAGTO thyristor having no beveled structure but a RESURF structure at a junction edge. In this case, reference numeral 100 denotes a semiconductor pellet; 24, electrode members; and 25, electrode posts (e.g., Cu) arranged to compress both the surfaces of the semiconductor pellet 100 through the electrode members 24.

Referring to Fig. 10, reference numeral 1001 denotes an anode electrode; 1002, a p-type emitter (anode) region; 1003, n⁺-type buffer layer; 1004, an n⁻-type base layer; 1005, p-type base regions; 1006, an n⁺-type emitter layer; 1007, gate insulating films; 1008, gate electrodes; 1009, base electrodes; 1010 and 1011, insulating films; 1012, cathode electrodes; 1013, a p⁺-type region; 1014, a p⁻-type RESURF region; 1015, an n⁺-type stopper layer; 1016, an oxide film; and 1017, an SIPOS film.

As has been described, an RESURF structure is formed in the junction edge. The RESURF structure, which serves to increase the breakdown voltage of the junction edge, will now be described in detail. That is, the p⁺-type region 1013 is formed outside the p-type outermost base region 1005 to have an interval, and the RESURF region 1014 serving as the p⁻-type region 1013 is formed outside the p⁺-type region 1013 to be in contact with it. The n⁺-type stopper region 1015 is formed at the edge portion of the pellet. The insulating oxide film 1016 is formed on the semiconductor surface between the RESURF region 1014 and the stopper region 1015, and a high-resistance layer called by an SIPOS layer, both the sides of which are connected to the p⁺-type region 1013 and the stopper region 1015, is formed on the insulating oxide film 1016. Therefore, a surface electric field is controlled by an electric field corresponding to a voltage drop between the anode and the cathode in the SIPOS layer to moderate a change in semiconductor surface electric field between the p⁺-type region 1013 and the n⁺-type stopper region 1015, thereby increasing a breakdown voltage of the junction edge portion. Since this structure is shallower than the above guard ring structure, it is particularly suitable for a case wherein a thin pellet such as an MAGTO thyristor is used.

In this embodiment, according to the present invention, an electron beam is radiated onto a junction edge region 100' of the pellet edge portion serving as a heat generating portion located outside the region contacting the cathode electrode 1012 directly connected to the electrode members 24 to partially control a carrier life time and to form an electron beam radiated portion H in a region indicated by dotted oblique lines, thereby increasing the breakdown voltage.

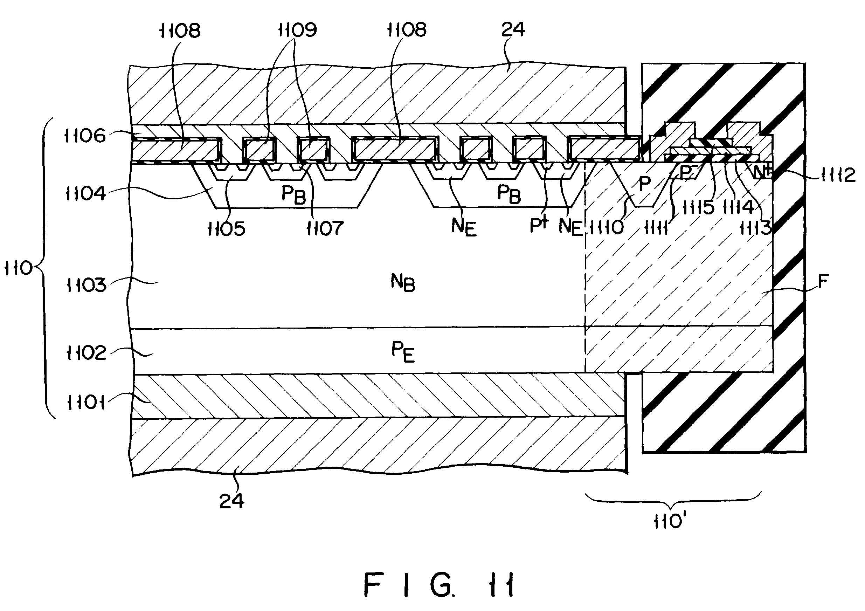

Fig. 11 shows a structure of a MOS controlled thyristor (MCT) having a RESURF structure in the same manner as described above. This thyristor has the following arrangement. That is, a stacked structure consists of an anode electrode 1101, a p-type emitter region 1102, and an n-type base region 1103, and a p-type well base region 1104 and an n-type emitter region 1105 formed therein are provided in the upper surface region of the n-type base region 1103. A cathode electrode 1106 is in contact with the surface of the n-type emitter region 1105. In addition, a p⁺-type region 1107 is formed in the n-type emitter region 1105. A gate electrode 1108 is formed on the semiconductor pellet surface between the p-type well base regions through a thin oxide film, and the gate electrode 1108 extends between surfaces of the p⁺-type regions 1107. A gate electrode 1109 is formed on the surface between the n-type emitter regions 1105 formed in the p-type well base region 1104, and a gate electrode 1109 extends between surfaces of the p⁺-type regions 1107 located to both the sides of the n-type emitter region 1105 in the same manner as described above.

This thyristor is turned on by applying a positive pulse to the gate electrode 1108 and turned off by applying a negative pulse to the gate electrodes 1108 and 1109.

As in Fig. 10, a p-type region 1110, p-type RESURF region 1111, and an n⁺-type stopper region 1112 are formed on a region near the upper surface of the edge portion of the thyristor. A high-resistance SIPOS layer 1114 having a high resistance is formed on the surface through an SiO₂ layer 1113. The upper surface of the SIPOS layer is covered with the CVD insulating layer 1115. Since the operation of this part is the same as in Fig. 10, a description of this operation will be omitted.

In this device, according to the present invention, an electron beam is radiated onto a junction edge region 110' of the pellet edge portion serving as a heat generating portion located outside a region contacting the cathode electrode 1106 directly connected to the electrode members 24 to partially control a carrier life time to form an electron beam radiated portion F in a region indicated by dotted oblique lines. Therefore, the breakdown voltage can be increased.

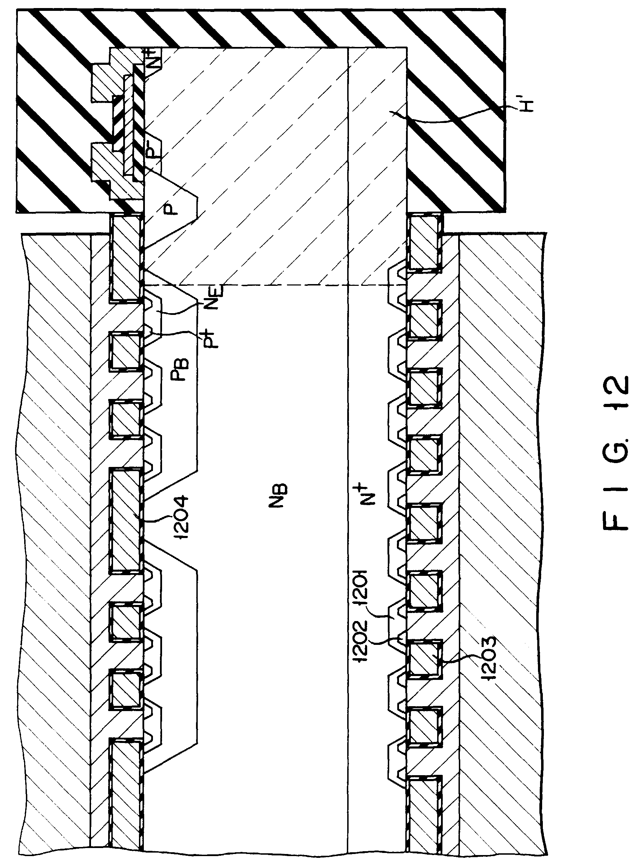

Fig. 12 shows an example wherein the present invention is applied to a double gate MCT having a RESURF structure.

The p-type emitter regions, which are the lowest layers of the double gate MCT, are p-type well emitter regions 1201 buried in the n⁺-type region. Two n⁺-type regions 1202 are formed in each of the p-type well emitter regions 1201. Further, gate electrode 1203 are provided on the lower major surface of the pellet, as on the upper major surface thereof. These structural features distinguish from the embodiment showed Fig. 11. Negative and positive pulse voltages are applied to the gate electrode 1204 on the upper surface and to the gate electrode 1203 on the lower surface, respectively, when the thyristor is turned off. Thus, a turn-off operation can be performed at a high speed.

In this MCT, the same RESURF structure as in Fig. 11 is provided to the edge portion, an electron beam is radiated onto a region H' on which the RESURF structure is formed. Thus, a carrier life time can be decreased, and a breakdown voltage can be increased.

When the present invention is applied to an alloy free compression bonded semiconductor device described in the above embodiments, the present invention is effective. Even when the present invention is applied to an alloy compression semiconductor device, the same effect as described above can be obtained as a matter of course.

In the above embodiments, although a compression bonded semiconductor device having a structure using a single semiconductor pellet is described above, even when the present invention is applied to a compression bonded semiconductor device having a structure using a plurality of semiconductor pellets, the same effect as described above can be obtained.

## Claims

1. A compression contacted semiconductor device comprising first and second main electrodes (22) formed respectively, on first and second opposing major surfaces of a semiconductor chip (20) having at least one pn junction, an electrode member (24) arranged on at least one of said main electrodes, thus forming a layered unit along with said chip, and a pair of electrode posts sandwiching said layered unit, thus compressing said electrodes formed on each major surface of said chip with said electrode member interposed between at least one of said electrode posts and said main electrodes, wherein said first major surface has an edge portion (A) extending from the periphery of said first main electrode to the edge of said semiconductor chip;
characterized in that the crystal defect density within the surface of said chip (20) within a region spanning the entire edge portion is higher than the crystal defect density of said chip beneath the main electrodes so that the carrier life time within said edge portion region (A) is shorter than the carrier life time beneath said main electrodes.

2. A compression contacted semiconductor device according to claim 1, wherein said first and second main electrodes are the same size.

3. A compression contacted semiconductor device according to claim 1, wherein said first main electrode is smaller.

4. A compression contacted semiconductor device according to any one of claims 1 to 3, characterized in that the crystal defect density of said edge portion region (A) is not less than about 1.5 times the crystal defect density beneath said main electrodes.

5. A compression contacted semiconductor device according to any one of claims 1 to 3, characterized in that at least one of said main electrodes of said semiconductor chip (70) is formed as an emitter pattern (76), and a part (76') of said emitter pattern (76) is arranged within said edge portion region.

6. A compression contacted semiconductor device according to any one of claims 1 to 4, characterized in that the distribution of said crystal defect density is controlled in the direction of depth of said semiconductor chip.

7. A compression contacted semiconductor device according to claim 6, characterized in that the position of maximum defect density is located at a depth of less than 200 µm from a major surface.

8. A compression contacted semiconductor device according to any one of claims 1 to 6, which has an alloy-free structure whereby
said semiconductor chip, said electrode member, and said electrode posts are in contact but not fixed to one another.

9. A compression contacted semiconductor device according to any one of claims 1 to 8, characterized in that said compression contacted semiconductor device is a compression bonded diode.

10. A compression contacted semiconductor device according to any one of claims 1 to 8, characterized in that said compression contacted semiconductor device is selected from a group consisting of a thyristor, a gate turn off thyristor, a static induction thyristor, an insulated gate bipolar transistor, a MOS assisted gate trigger thyristor, a MOS assisted gate turn off thyristor, a reverse blocking gate turn off thyristor, a reverse conducting gate turn off thyristor, and a MOS controlled thyristor.

11. A compression contacted semiconductor device according to any one of claims 1 to 10, characterized in that said junction intersects a major surface of said compression contacted semiconductor device.

12. A compression contacted semiconductor device according to any one of claims 1 to 11, characterized in that said compression contacted semiconductor device has a beveled structure.

13. A compression contacted semiconductor device according to any one of claims 1 to 11, characterized in that said compression contacted semiconductor device is an alloy-free MOS assisted gate turn off thyristor, whereby said chip, said electrode members and said electrode posts are in contact but not fixed to one another.

14. A method of forming a compression-contacted semiconductor device comprising the steps of:
forming a semiconductor chip (20) having a predetermined carrier life time by uniformly directing a charge particle beam onto an entire major surface of said semiconductor chip (20), said chip comprising at least one pn junction and first and second opposing major surfaces having first and second main electrodes, respectively, thereon; whereby an edge portion (A) extends from the periphery of said first main electrode to the edge of said semiconductor chip;
selectively forming a mask on said semiconductor chip (20) except for said edge portion;
forming a region across the entire edge portion having a defect density higher than the defect density beneath said main electrodes on which said mask is not formed to decrease the carrier life time in the edge portion region; and
removing said mask from said semiconductor chip.

15. A method according to claim 14, characterized in that a charged particle beam is used to form said region having a higher defect density.

16. A method according to claim 14, characterized in that a diffusion of heavy metal is used to form said region having a higher defect density.

17. A method according to claims 15 or 16, characterized in that said charged particle beam is an electron beam.

18. A method according to claims 15 or 16, characterized in that said charged particle beam is a charged particle beam having a mass larger than an electron.

19. A method according to claim 18, characterized in that said charged particle beam is selected from a group consisting of a proton beam (H⁺) an a helium beam (He⁺).

## Patentansprüche

1. Kompressionskontaktierte Halbleitervorrichtung, die folgendes aufweist: erste und zweite Hauptelektroden (22), die jeweils auf ersten und zweiten gegenüberliegenden Hauptoberflächen eines Halbleiterchips (20) mit wenigstens einem pn-Übergang ausgebildet sind, ein Elektrodenelement (24), das auf wenigstens einer der Hauptelektroden angeordnet ist, um somit eine geschichtete Einheit zusammen mit dem Chip auszubilden, und ein Paar von Elektrodensäulen, die die geschichtete Einheit von beiden Seiten umgeben, um somit die Elektroden zu komprimieren, die auf jeder Hauptoberfläche des Chips ausgebildet sind, wobei das Elektrodenelement zwischen wenigstens einer der Elektrodensäulen und den Hauptelektroden angeordnet ist, wobei die erste Hauptoberfläche einen Randteil (A) aufweist, der sich von der Peripherie der ersten Hauptelektrode zum Rand des Halbleiterchips erstreckt;
dadurch gekennzeichnet, daß die Kristalldefektdichte innerhalb der Oberfläche des Chips (20) innerhalb eines Bereichs, der den gesamten Randteil überspannt, höher als die Kristalldefektdichte des Chips unterhalb der Hauptelektroden ist, so daß die Träger-Lebensdauer innerhalb des Randteilbereichs (A) kürzer als die Träger-Lebensdauer unterhalb der Hauptelektroden ist.

2. Kompressionskontaktierte Halbleitervorrichtung nach Anspruch 1, wobei die erste und die zweite Hauptelektrode dieselbe Größe aufweisen.

3. Kompressionskontaktierte Halbleitervorrichtung nach Anspruch 1, wobei die erste Hauptelektrode kleiner ist.

4. Kompressionskontaktierte Halbleitervorrichtung nach einem der Ansprüche 1 bis 3, dadurch gekennzeichnet, daß die Kristalldefektdichte des Randteilbereichs (A) nicht kleiner als etwa das 1,5-fache der Kristalldefektdichte unterhalb der Hauptelektroden ist.

5. Kompressionskontaktierte Halbleitervorrichtung nach einem der Ansprüche 1 bis 3, dadurch gekennzeichnet, daß wenigstens eine der Hauptelektroden des Halbleiterchips (70) als Emittermuster (76) ausgebildet ist, und ein Teil (76') des Emittermusters (76) innerhalb des Randteilbereichs angeordnet ist.

6. Kompressionskontaktierte Halbleitervorrichtung nach einem der Ansprüche 1 bis 4, dadurch gekennzeichnet, daß die Verteilung der Kristalldefektdichte in der Richtung der Tiefe des Halbleiterchips gesteuert wird.

7. Kompressionskontaktierte Halbleitervorrichtung nach Anspruch 6, dadurch gekennzeichnet, daß die Position der maximalen Defektdichte bei einer Tiefe von weniger als 200 µm von einer Hauptoberfläche angeordnet ist.

8. Kompressionskontaktierte Halbleitervorrichtung nach einem der Ansprüche 1 bis 6, welche eine legierungsfreie Struktur hat, wobei
der Halbleiterchip, das Elektrodenelement und die Elektrodensäulen in Kontakt aber nicht aneinander fixiert sind.

9. Kompressionskontaktierte Halbleitervorrichtung nach einem der Ansprüche 1 bis 8, dadurch gekennzeichnet, daß die kompressionskontaktierte Halbleitervorrichtung eine kompressionsbondierte Diode ist.

10. Kompressionskontaktierte Halbleitervorrichtung nach einem der Ansprüche 1 bis 8, dadurch gekennzeichnet, daß die kompressionskontaktierte Halbleitervorrichtung aus einer Gruppe ausgewählt ist, die aus einem Thyristor, einem Gate-Ausschalt-Thyristor, einem Statikinduktions-Thyristor, einem Bipolartransistor mit isoliertem Gate, einem MOS-unterstützten Gate-Trigger-Thyristor, einem MOS-unterstützten Gate-Ausschalt-Thyristor, einem umgekehrt blockierenden Gate-Ausschalt-Thyristor, einem umgekehrt leitenden Gate-Ausschalt-Thyristor und einem MOS-gesteuerten Thyristor besteht.

11. Kompressionskontaktierte Halbleitervorrichtung nach einem der Ansprüche 1 bis 10, dadurch gekennzeichnet, daß der Übergang eine Hauptoberfläche der kompressionskontaktierten Halbleitervorrichtung schneidet.

12. Kompressionskontaktierte Halbleitervorrichtung nach einem der Ansprüche 1 bis 11, dadurch gekennzeichnet, daß die kompressionskontaktierte Halbleitervorrichtung eine abgeschrägte Struktur hat.

13. Kompressionskontaktierte Halbleitervorrichtung nach einem der Ansprüche 1 bis 11, dadurch gekennzeichnet, daß die kompressionskontaktierte Halbleitervorrichtung ein legierungsfreier MOS-unterstützter Gate-Ausschalt-Thyristor ist, wobei der Chip, die Elektrodenelemente und die Elektrodensäulen in Kontakt aber nicht aneinander fixiert sind.

14. Verfahren zum Ausbilden einer kompressionskontaktierten Halbleitervorrichtung, das folgende Schritte aufweist: Ausbilden eines Halbleiterchips (20) mit einer vorbestimmten Träger-Lebensdauer durch einheitliches Richten eines Ladungspartikelstrahls auf eine gesamte Hauptoberfläche des Halbleiterchips (20), wobei der Chip wenigstens einen pn-Übergang und erste und zweite gegenüberliegende Hauptoberflächen mit jeweiligen ersten und zweiten Hauptelektroden darauf aufweist; wobei ein Randteil (A) sich von der Peripherie der ersten Hauptelektrode zum Rand des Halbleiterchips erstreckt; selektives Ausbilden einer Maske auf dem Halbleiterchip (20) außer für den Randteil;
Ausbilden eines Bereichs über dem gesamten Randteil mit einer Defektdichte, die größer als die Defektdichte unterhalb der Hauptelektroden ist, auf denen die Maske nicht ausgebildet ist, um die Träger-Lebensdauer im Randteilbereich zu verringern; und Entfernen der Maske vom Halbleiterchip.

15. Verfahren nach Anspruch 14, dadurch gekennzeichnet, daß der geladene Partikelstrahl zum Ausbilden des Bereichs mit höherer Defektdichte verwendet wird.

16. Verfahren nach Anspruch 14, dadurch gekennzeichnet, daß eine Diffusion von Schwermetall zum Bilden des Bereichs mit einer höheren Defektdichte verwendet wird.

17. Verfahren nach Anspruch 15 oder 16, dadurch gekennzeichnet, daß der geladene Partikelstrahl ein Elektronenstrahl ist.

18. Verfahren nach Anspruch 15 oder 16, dadurch gekennzeichnet, daß der geladene Partikelstrahl ein geladener Partikelstrahl mit einer Masse ist, die größer als ein Elektron ist.

19. Verfahren nach Anspruch 18, dadurch gekennzeichnet, daß der geladene Partikelstrahl aus einer Gruppe ausgewählt wird, die aus einem Protonenstrahl (H⁺) und einem Heliumstrahl (He⁺) besteht.

## Revendications

1. Dispositif à semiconducteur à contact par compression comprenant des première et seconde électrodes principales (22) formées respectivement sur des première et seconde surfaces principales opposées d'une puce à semiconducteur (20) comportant au moins une jonction PN, un élément d'électrode (24) agencé sur au moins l'une desdites électrodes principales pour ainsi former une unité en couches avec ladite puce et deux piliers d'électrode prenant en sandwich ladite unité en couches, pour ainsi comprimer lesdites électrodes formées sur chaque surface principale de ladite puce, ledit élément d'électrode étant interposé entre au moins l'un desdits piliers d'électrode et au moins l'une desdites électrodes principales, dans lequel ladite première surface principale comporte une partie de bord (A) s'étendant depuis la périphérie de ladite première électrode principale jusqu'au bord de ladite puce à semiconducteur,
caractérisé en ce que la densité de défauts cristallins dans la surface de ladite puce (20) dans une région englobant la totalité de la partie de bord est supérieure à la densité de défauts cristallins de ladite puce au-dessous des électrodes principales de telle sorte que la durée de vie des porteurs à l'intérieur de ladite région de partie de bord (A) est inférieure à la durée de vie des porteurs au-dessous desdites électrodes principales.

2. Dispositif à semiconducteur à contact par compression selon la revendication 1, dans lequel lesdites première et seconde électrodes principales sont de la même dimension.

3. Dispositif à semiconducteur à contact par compression selon la revendication 1, dans lequel ladite première électrode principale est plus petite.

4. Dispositif à semiconducteur à contact par compression selon l'une quelconque des revendications 1 à 3, caractérisé en ce que la densité de défauts cristallins de ladite région de partie de bord (A) n'est pas inférieure à environ 1,5 fois la densité de défauts cristallins au-dessous desdites électrodes principales.

5. Dispositif à semiconducteur à contact par compression selon l'une quelconque des revendications 1 à 3, caractérisé en ce qu'au moins l'une desdites électrodes principales de ladite puce à semiconducteur (70) est formée en tant que motif d'émetteur (76) et une partie (76') dudit motif d'émetteur (76) est agencée à l'intérieur de ladite région de partie de bord.

6. Dispositif à semiconducteur à contact par compression selon l'une quelconque des revendications 1 à 4, caractérisé en ce que la distribution de ladite densité de défauts cristallins est commandée suivant la direction de profondeur de ladite puce à semiconducteur

7. Dispositif à semiconducteur à contact par compression selon la revendication 6, caractérisé en ce que la position de la densité de défauts maximum est située à une profondeur inférieure à 200 µm depuis une surface principale.

8. Dispositif à semiconducteur à contact par compression selon l'une quelconque des revendications 1 à 6, lequel comporte une structure exempte d'alliage de telle sorte que ladite puce à semiconducteur, ledit élément d'électrode et lesdits piliers d'électrode soient en contact les uns avec les autres mais ne soient pas fixés les uns sur les autres.

9. Dispositif à semiconducteur à contact par compression selon l'une quelconque des revendications 1 à 8, caractérisé en ce que ledit dispositif à semiconducteur à contact par compression est une diode liée par compression.

10. Dispositif à semiconducteur à contact par compression selon l'une quelconque des revendications 1 à 8, caractérisé en ce que ledit dispositif à semiconducteur à contact par compression est choisi parmi un groupe comprenant un thyristor, un thyristor à coupure par gâchette, un thyristor à induction statique, un transistor bipolaire à grille isolée, un thyristor à déclenchement par gâchette assisté par MOS, un thyristor à coupure par gâchette assistée par MOS, un thyristor à coupure par gâchette à blocage inverse, un thyristor à coupure par gâchette à conduction inverse et un thyristor commandé par MOS.

11. Dispositif à semiconducteur à contact par compression selon l'une quelconque des revendications 1 à 10, caractérisé en ce que ladite jonction intersecte une surface principale dudit dispositif à semiconducteur à contact par compression.

12. Dispositif à semiconducteur à contact par compression selon l'une quelconque des revendications 1 à 11, caractérisé en ce que ledit dispositif à semiconducteur à contact par compression présente une structure biseautée.

13. Dispositif à semiconducteur à contact par compression selon l'une quelconque des revendications 1 à 11, caractérisé en ce que ledit dispositif à semiconducteur à contact par compression est un thyristor à coupure par gâchette assistée par MOS exempt d'alliage de telle sorte que ladite puce, lesdits éléments d'électrode et lesdits piliers d'électrode soient en contact les uns avec les autres mais ne soient pas fixés les uns sur les autres.

14. Procédé de formation d'un dispositif à semiconducteur à contact par compression comprenant les étapes de :
formation d'une puce à semiconducteur (20) présentant une durée de vie de porteurs prédéterminée en dirigeant uniformément un faisceau de particules chargées sur la totalité d'une surface principale de ladite puce à semiconducteur (20), ladite puce comprenant au moins une jonction PN et des première et seconde surfaces principales opposées comportant respectivement des première et seconde électrodes principales dessus de telle sorte qu'une partie de bord (A) s'étende depuis la périphérie de ladite première électrode principale jusqu'au bord de ladite puce à semiconducteur ;
formation sélective d'un masque sur ladite puce à semiconducteur (20) à l'exception de ladite partie de bord ;
formation d'une région sur la totalité de la partie de bord présentant une densité de défauts supérieure à la densité de défauts au-dessous desdites électrodes principales sur laquelle ledit masque n'est pas formé afin de diminuer la durée de vie des porteurs dans la région de partie de bord ; et
enlèvement dudit masque de ladite puce à semiconducteur

15. Procédé selon la revendication 14, caractérisé en ce qu'un faisceau de particules chargées est utilisé pour former ladite région présentant une densité de défauts plus élevée.

16. Procédé selon la revendication 14, caractérisé en ce qu'une diffusion de métal lourd est utilisée pour former ladite région présentant une densité de défauts plus élevée.

17. Procédé selon la revendication 15 ou 16, caractérisé en ce que ledit faisceau de particules chargées est un faisceau d'électrons.

18. Procédé selon la revendication 15 ou 16, caractérisé en ce que ledit faisceau de particules chargées est un faisceau de particules chargées présentant une masse supérieure à celle d'un d'électron.

19. Procédé selon la revendication 18, caractérisé en ce que ledit faisceau de particules chargées est choisi parmi le groupe comprenant un faisceau de protons (H⁺) et un faisceau d'hélium (He⁺).
